# FASCICULE DE BREVET EUROPEEN

(11) **EP 3 980 794 B1**
(45) Date de publication et mention de la délivrance du brevet: **14.08.2024**
(21) Numéro de dépôt: 20737248.3
(22) Date de dépôt: 19.05.2020
(51) Int. Cl.: G01R 27/20, G01R 31/327, G01R 31/66, G01R 31/00, B60R 16/023, G01R 31/40, G01R 31/55

(54) **SYSTEME ELECTRIQUE ET PROCEDE DE DIAGNOSTIC DE CONNEXION ELECTRIQUE DEFAILLANTE DANS UN SYSTEME ELECTRIQUE**
ELEKTRISCHES SYSTEM UND VERFAHREN ZUR DIAGNOSE EINER FEHLERHAFTEN ELEKTRISCHEN VERBINDUNG IN EINEM ELEKTRISCHEN SYSTEM
ELECTRICAL SYSTEM AND METHOD FOR DIAGNOSING A FAULTY ELECTRICAL CONNECTION IN AN ELECTRICAL SYSTEM

(30) Priorité: 06.06.2019 FR 1905983
(43) Date de publication de la demande: 13.04.2022
(73) Titulaire: Stellantis Auto SAS, 78300 Poissy (FR)
(72) Inventeur: RIERA, Alexis, 78480 VERNEUIL SUR SEINE (FR)
(86) Numéro de dépôt international: PCT/FR2020/050825
(87) Numéro de publication internationale: WO 2020/245519

(56) Documents cités:
- EP-A1- 3 240 131
- EP-A1- 3 324 196
- EP-A2- 2 695 762
- KR-A- 20180 134 205
- US-A1- 2007 115 604
- US-A1- 2017 059 657

## Description

L'invention concerne de manière générale la sécurité électrique dans les dispositifs et systèmes électriques. Plus particulièrement, l'invention se rapporte à un procédé de protection d'un système électrique en cas de connexion électrique défaillante. L'invention se rapporte aussi à un système électrique, notamment de véhicule automobile, dans lequel est mis en oeuvre le procédé susmentionné.

La sécurité électrique est un facteur important dans la conception automobile, surtout en présence de tensions et d'intensités élevées comme cela peut être le cas dans les véhicules à traction électrique.

Dans un système électrique, une connexion électrique défaillante peut être la cause d'un problème de sécurité. En effet, il peut en résulter des risques pour les personnes lorsque la tension est élevée, par exemple en cas déconnexion totale d'un connecteur, ainsi que des risques d'emballement thermique du fait d'une connexion électrique trop résistive, ou d'arc électrique, conduisant à la destruction d'une partie du système ou à un incendie

Dans l'état de la technique, Il est connu un connecteur équipé d'un dispositif qui verrouille le connecteur et empêche tout mouvement après que celui-ci ait été correctement mis en place. Le verrouillage du connecteur peut présenter une certaine complexité pour un opérateur. Cette solution est dépendante du facteur humain et peut conduire à des connexions incomplètes ou non verrouillées.

Il est également connu un connecteur équipé d'un capteur de branchement, dit « interlock line », qui autorise le diagnostic d'une déconnexion de connecteur par détection de l'ouverture d'un circuit fermé séparé intégré dans le connecteur à sa conception. Le circuit « interlock line » détecte la déconnexion et envoie un signal d'alerte. Les documents TW201608778A et CN105128679A décrivent des circuits de ce type qui indiquent un état de contact ou de non-contact. Cette solution de la technique antérieure présente l'inconvénient d'une sensibilité aux perturbations électromagnétiques qui augmente la probabilité de fausses détections.

Par le document EP0829731A, il est connu un système de contrôle de l'intégrité de connexions électriques qui comprend un transformateur ayant un enroulement primaire couplé entre un ensemble à deux prises de contact et un enroulement secondaire couplé à la fois à une source d'énergie et à un circuit de contrôle. La source d'énergie, sous la forme d'un oscillateur radiofréquence, alimente l'enroulement secondaire du transformateur qui est connecté au circuit de contrôle. Un circuit de référence en courant est couplé à l'enroulement secondaire du transformateur et comporte une sortie couplée à la source d'énergie et au circuit de contrôle. Lorsque le contact est établi, l'impédance de l'enroulement secondaire prend une valeur basse qui est détectée par le circuit de contrôle.

On connait en outre les documents de brevets US-A1-2007115604, EP-A2-2695762, EP-A1-3240131, KR-A-20180134205 et EP-A1-3324196 dont le document de brevet EP-A2-2695762 est conforme au préambule de la revendication 1.

Il est souhaitable de palier aux inconvénients de la technique antérieure en proposant un nouveau procédé pour sécuriser un système électrique vis-à-vis des risques électriques, par un diagnostic précoce et économiquement avantageux de connexions électriques défaillantes.

Selon un premier aspect, l'invention concerne un procédé de diagnostic de connexion électrique défaillante dans un système électrique comprenant au moins une source de puissance électrique et au moins un composant électrique reliés électriquement à travers un commutateur électrique, le procédé comprenant les étapes de a) mesurer des première et deuxième tensions électriques présentes entre des bornes de la source de puissance électrique et du composant électrique, b) calculer un écart de tension entre les première et deuxième tensions électriques, c) comparer l'écart de tension à un seuil de tension prédéterminé, d) diagnostiquer une connexion électrique défaillante entre la source de puissance électrique et le composant électrique en fonction du résultat de la comparaison, et e) commander une ouverture du commutateur électrique et/ou une émission d'un signal d'alerte dans le cas où une connexion électrique défaillante est diagnostiquée, le seuil de tension étant prédéterminé égal à une chute de tension maximale normale entre la source de puissance électrique et le composant électrique lorsque la connexion électrique est normale, multipliée par un facteur de marge de sécurité.

Selon une caractéristique particulière, la connexion électrique est diagnostiquée défaillante lorsque l'écart de tension excède le seuil de tension prédéterminé pendant au moins une durée prédéterminée.

Selon encore une autre caractéristique particulière, la chute de tension maximale normale est égale au produit d'un courant électrique maximal pouvant circuler entre la source de puissance électrique et le composant électrique lorsque la connexion électrique est normale et d'une résistance électrique nominale du circuit électrique entre la source de puissance électrique et le composant électrique.

Selon encore une autre caractéristique particulière, dans un système électrique comprenant une source de puissance électrique et une pluralité de composants électriques reliés électriquement à travers un commutateur électrique à la source de puissance électrique, le procédé selon l'invention prévoit que le diagnostic d'une connexion électrique défaillante entre la source de puissance électrique et au moins un des composants électriques provoque une commande d'ouverture du commutateur électrique pour au moins le circuit électrique dans lequel est diagnostiquée la connexion électrique défaillante et/ou l'émission d'au moins un signal d'alerte.

L'invention concerne aussi un système électrique comprenant au moins une source de puissance électrique et au moins un composant électrique reliés électriquement à travers un commutateur électrique, le commutateur électrique étant piloté en commutation par une unité électronique de commande. Conformément à l'invention, la source de puissance électrique et le composant électrique comportent chacun un dispositif de mesure de tension mesurant une tension électrique à leurs bornes et l'unité électronique de commande comprend une mémoire stockant des instructions de programme pour la mise en oeuvre du procédé tel que décrit brièvement ci-dessus.

L'invention concerne aussi un véhicule automobile comprenant le système électrique susmentionné.

D'autres avantages et caractéristiques de la présente invention apparaîtront plus clairement à la lecture de la description détaillée ci-dessous de plusieurs formes de réalisation particulières de l'invention, en référence aux dessins annexés, dans lesquels :
[Fig.1] La Fig.1 est un bloc-diagramme d'une forme de réalisation particulière d'un système électrique dans lequel est mis en oeuvre le procédé selon l'invention.
[Fig.2] La Fig.2 est un logigramme montrant différentes étapes fonctionnelles du procédé selon l'invention.

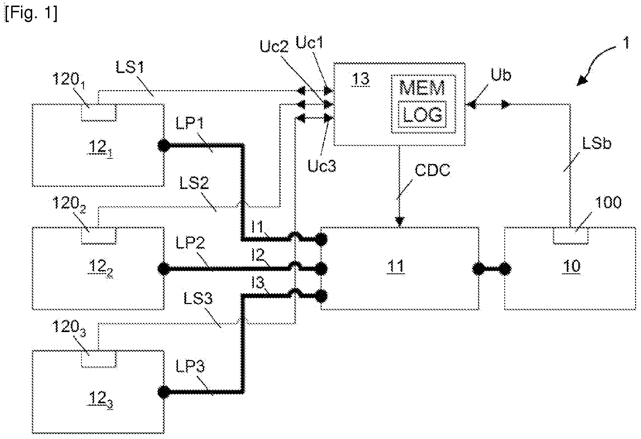

En référence à la Fig.1, il est maintenant décrit, à titre d'exemple, une forme de réalisation particulière 1 d'un système électrique dans lequel est mis en oeuvre le procédé selon l'invention.

Comme montré à la Fig.1, le système électrique 1 comprend une source de d'énergie électrique 10, un commutateur 11, une pluralité de composants électriques, ici trois composants électriques 12₁ à 12s, et une unité électronique de commande 13.

La source de puissance électrique 10 est, par exemple, une batterie d'accumulateurs telle qu'une batterie de traction dans un véhicule électrique ou hybride. La source de puissance électrique 10 est équipée d'un dispositif de mesure de tension 100 mesurant une tension d'alimentation Ub aux bornes de la source 10.

Le commutateur 11 est disposé entre la source de puissance électrique 10 et les composants électriques 12₁ à 12₃ et est commandé en commutation par l'unité électronique de commande 13, à travers une commande de commutation CDC délivrée par celui-ci. Le commutateur 11 pourra être, par exemple, intégré dans la source de puissance électrique 10 ou séparé de celle-ci.

Le commutateur 11 autorise ou interdit le passage de courants électriques de puissance I1 à I3 entre la source de puissance électrique 10 et les composants électriques 12₁ à 12₃ selon l'état fermé ou ouvert dans lequel il se trouve. Le commutateur 11 est ainsi un moyen de couper la transmission de la puissance électrique entre la source de puissance électrique 10 et les composants électriques 12₁ à 12₃.

Selon la forme de réalisation, les courants électriques de puissance I1 à I3 pourront être commutés individuellement ou collectivement. Dans le premier cas, le commutateur 11 comprendra typiquement trois contacteurs électriques, ou interrupteurs électroniques de puissance, commandés individuellement en commutation. Dans le second cas, le commutateur 11 comprendra typiquement un contacteur électrique, ou interrupteur électronique de puissance, ou plusieurs de ceux-ci en parallèle, pour passer l'intensité, commandés simultanément en commutation.

Les composants électriques 12₁ à 12₃ sont des consommateurs électriques et/ou des générateurs électriques, comme par exemple, dans un véhicule automobile, un moteur électrique, un alternateur électrique ou une machine électrique tournante réversible d'hybridation.

Les composants électriques 12₁ à 12₃ sont équipés de dispositifs de mesure de tension 120₁ à 120₃ mesurant des tensions d'alimentation Uc1 à Uc3 à leurs bornes, respectivement.

Les composants électriques 12₁ à 12₃ sont connectés électriquement à la source de puissance électrique 10, via le commutateur 11, par des liaisons d'alimentation électrique LP1 à LP3 dans lesquelles circulent les courants électriques I1 à I3, respectivement.

L'unité électronique de commande 13 comporte une mémoire MEM dans laquelle est hébergé un module logiciel LOG pour la mise en oeuvre du procédé selon l'invention. Le procédé selon l'invention est mis être mis en oeuvre par l'exécution d'instructions de code de programme du module logiciel, par un processeur (non représenté) de l'unité 13.

L'unité électronique de commande 13 est reliée aux dispositifs de mesure de tension 100 et 120₁ à 120₃ par des liaisons de signal LSb et LS1 à LS3, respectivement. A travers ces liaisons de signal LSb et LS1 à LS3, l'unité électronique de commande 13 configure des mesures périodiques des tensions d'alimentation Ub et Uc1 à Uc3 par les dispositifs 100 et 120₁ à 120₃ et reçoit en entrée ces tensions d'alimentation Ub et Uc1 à Uc3 mesurées, respectivement.

Le principe de l'invention repose sur la détection d'une chute de tension excédentaire, due à une résistance électrique accrue anormale entre un composant électrique et la source de puissance électrique, pour diagnostiquer une connexion électrique défaillante entre ceux-ci. En effet, lorsque des contacts électriques se séparent progressivement dans un connecteur, la résistance électrique entre eux augmente, car leur surface de contact diminue, et produit une chute de tension supplémentaire dans le circuit électrique. De même, lorsqu'un arc électrique se produit dans un circuit électrique entre deux extrémités de contact, une chute de tension accrue apparaît entre ces deux extrémités.

La loi d'Ohm permet de calculer la chute de tension normale attendue entre la source de puissance électrique 10 et le composant électrique considéré 12₁, 12₂ ou 12₃, lorsqu'un courant électrique circule dans le circuit électrique formé entre eux et dont la résistance nominale est connue par conception. Lorsqu'une chute de tension supérieure à la chute de tension normale attendue est mesurée entre la source de puissance électrique 10 et le composant électrique considéré 12₁, 12₂ ou 12₃, l'excédent de chute de tension détecté est dû à une résistance parasite qui s'ajoute à la résistance nominale du circuit électrique et qui est révélatrice d'une connexion électrique défaillante.

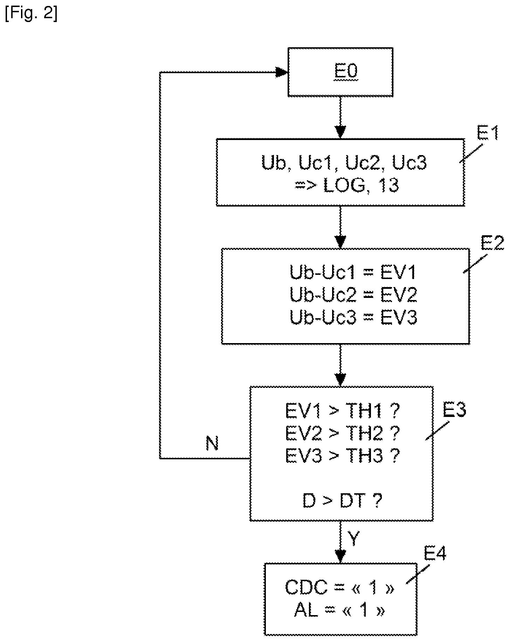

Le procédé selon l'invention et le fonctionnement du système électrique 1 sont maintenant décrits en référence aussi à la Fig.2.

Différentes étapes fonctionnelles du procédé selon l'invention sont représentées à la Fig.2 par des blocs E0 à E4.

Le bloc E0 correspond à un état initial du système électrique 1 dans un mode de fonctionnement nominal dans lequel le commutateur 11 est fermé et les composants électriques 12₁, 12₂ et 12₃ sont alimentées par la source de puissance électrique 10 avec les courants I1, I2 et I3.

Le bloc E1 correspond aux mesures périodiques des tensions d'alimentation Ub et Uc1 à Uc3 de la source de puissance électrique 10 et des composants électriques 12₁, 12₂ et 12₃ par les dispositifs de mesure de tension 100 et 120₁, 120₂ et 120₃. Les tensions d'alimentation Ub et Uc1 à Uc3 mesurées sont transmises à l'unité électronique de commande 13 pour être lues par le module logiciel LOG.

Dans le bloc E2, le processus de commande du module logiciel LOG calcule des écarts de tension EV1 à EV3 entre la tension Ub et les tensions Uc1 à Uc3, à savoir, EV1=Ub-Uc1, EV2=Ub-Uc2 et EV3=Ub-Uc3.

Dans le bloc conditionnel E3, le processus de commande du module logiciel LOG compare respectivement les écarts de tension EV1 à EV3 à des seuils de tension TH1 à TH3 préalablement définis.

Dans le cas (N) où le processus ne détecte aucun dépassement significatif des seuils de tension TH1 à TH3 par les écarts de tension EV1 à EV3, le processus de commande maintient le système électrique 1 dans son mode de fonctionnement nominal et boucle sur le bloc E0.

Le bloc E4 correspond au cas (Y) où au moins un des écarts de tension EV1 à EV3 est détecté dans le bloc E3 comme étant supérieur à un seuil de tension correspondant parmi les seuils de tension TH1 à TH3. Le dépassement de seuil de tension est confirmé lorsque celui-ci est constaté pendant une durée D supérieure à une durée de confirmation prédéterminée DT. Lorsqu'un dépassement de seuil validé est détecté, le processus de commande diagnostique alors une connexion électrique défectueuse dans le circuit électrique du ou des composants électriques concernés et peut décider d'émettre un signal l'alerte AL (AL= « 1 ») et/ou d'activer la commande de commutation CDC (CDC = « 1 ») pour commuter en ouverture le commutateur 11. L'émission seulement du signal l'alerte AL correspondra typiquement à une situation de vie qui ne présente aucun danger ou risque électrique immédiat. Dans un véhicule, le signal l'alerte AL, par exemple sous la forme d'un voyant lumineux activé dans le tableau de bord, informera le conducteur de la nécessité d'une intervention de réparation. La commutation en ouverture du commutateur 11 correspondra typiquement à une situation de vie présentant un danger ou un risque électrique et qui requiert une coupure de l'alimentation électrique.

Différentes stratégies de commande du commutateur 11 pourront être exécutées par le processus de commande selon la configuration du système électrique 1 et/ou les situations de vie. Ainsi, le processus de commande pourra décider de couper l'alimentation électrique de l'ensemble des composants électriques dès qu'un dépassement d'au moins un des seuils de tension TH1 à TH3 est détecté, afin de sécuriser complètement le système électrique 1. Ou bien, le processus de commande pourra décider de ne couper l'alimentation électrique que du ou des composants électriques concernés par un dépassement de seuil de tension, afin de préserver le fonctionnement du système électrique, dans un mode dégradé, en maintenant en fonctionnement un maximum de composants électriques. Dans ce dernier cas, par exemple, le processus de commande aura estimé que la coupure des composants électriques concernés par un dépassement de seuil de tension ne provoque pas d'effets indésirables et que l'alimentation électrique pour les autres composants électriques peut être maintenue sans aucun danger.

Les seuils de tension TH1 à TH3 sont prédéfinis respectivement pour les composants électriques 12₁ à 12₃. Dans l'exemple particulier de réalisation du système électrique 1, pour chacun des composants électriques, le seuil de tension respectif est fixe et dépend du courant électrique maximal qui peut circuler entre la source de puissance électrique et le composant électrique et de la résistance électrique nominale du circuit électrique entre le composant électrique et la source de puissance électrique.

Ainsi, par exemple, pour un composant électrique considéré, désigné 12, ayant une résistance électrique nominale R=5 mOhm pour son circuit électrique avec la source de puissance électrique 10, et un courant électrique maximal Imax=100 A, la chute de tension maximale Umax entre la source de puissance électrique 10 et le composant électrique 12 sera égale à Umax=R.Imax=500 mV. En prenant un facteur de marge de sécurité M, par exemple égale à M=2, le seuil de tension, désigné TH, affecté au composant électrique 12 sera prédéfini à TH=M.Umax=1 V. En considérant une durée de confirmation DT fixée par exemple à DT=5 s, si la tension d'alimentation, désignée Uc, aux bornes du composant électrique 12 est inférieure d'au moins TH=1V à celle Ub de la source de puissance électrique 10 pendant une durée supérieure à DT=5, alors la commande de commutation CDC est activée (CDC = « 1 ») pour commuter en ouverture le commutateur 11.

Dans d'autres formes de réalisation, afin d'obtenir un diagnostic plus précis, plusieurs seuils de tension pourront être définis pour un même composant électrique, en fonction de l'intensité ou de plages d'intensité du courant consommé ou produit par le composant électrique.

On notera que le procédé de l'invention autorise une détermination aisée de la localisation du défaut de résistance électrique et facilite ainsi les opérations de réparation après-vente.

Ainsi, dans le cas où un dépassement de seuil de tension est détecté pour l'ensemble des composants électriques, le défaut de résistance électrique sera alors identifié au niveau du mode commun de la source de puissance électrique.

Dans le cas où un seul dépassement de seuil de tension est détecté, le défaut de résistance électrique est situé dans le circuit électrique entre le composant électrique concerné et la source de puissance électrique.

Dans le cas où plus d'un dépassement de seuil de tension sont détectés, le défaut de résistance électrique est situé dans les portions de circuit électrique communes des composants électriques concernés.

L'invention ne se limite pas aux formes de réalisation particulières qui ont été décrites ici à titre d'exemple. L'homme du métier, selon les applications de l'invention, pourra apporter différentes modifications et variantes entrant dans le champ de protection de l'invention.

## Revendications

1. Procédé de diagnostic de connexion électrique défaillante dans un système électrique (1) comprenant au moins une source de puissance électrique (10) et au moins un composant électrique (12₁ à 12₃) reliés électriquement à travers un commutateur électrique (11), ledit procédé comprenant les étapes de a) mesurer des première et deuxième tensions électriques (Ub ; Uc1 à Uc3) présentes entre des bornes de ladite source de puissance électrique (10) et dudit composant électrique (12₁ à 12s), b) calculer un écart de tension (EV1 à EV3) entre lesdites première et deuxième tensions électriques (Ub ; Uc1 à Uc3), c) comparer ledit écart de tension (EV1 à EV3) à un seuil de tension prédéterminé (TH1 à TH3), d) diagnostiquer une connexion électrique défaillante entre ladite source de puissance électrique (10) et ledit composant électrique (12₁ à 12s) en fonction du résultat de ladite comparaison, et e) commander une ouverture (CDC) dudit commutateur électrique (11) et/ou une émission d'un signal d'alerte (AL) dans le cas où une connexion électrique défaillante est diagnostiquée, **caractérisé en ce que** ledit seuil de tension (TH1 à TH3) est prédéterminé égal à une chute de tension maximale normale (Umax) entre ladite source de puissance électrique (10) et ledit composant électrique (12₁ à 12₃) lorsque ladite connexion électrique est normale, multipliée par un facteur de marge de sécurité (M).

2. Procédé selon la revendication 1, **caractérisé en ce que** ladite chute de tension maximale normale (Umax) est égale au produit d'un courant électrique maximal (Imax) pouvant circuler entre ladite source de puissance électrique (10) et ledit composant électrique (12₁ à 12₃) lorsque ladite connexion électrique est normale et d'une résistance électrique nominale (R) du circuit électrique entre ladite source de puissance électrique (10) et ledit composant électrique (12₁ à 12s).

3. Procédé selon la revendication 1 ou 2, **caractérisé en ce que** ladite connexion électrique est diagnostiquée défaillante lorsque ledit écart de tension (EV1 à EV3) excède ledit seuil de tension prédéterminé (TH1 à TH3) pendant au moins une durée prédéterminée (DT).

4. Procédé selon l'une quelconque des revendications 1 à 3, dans un système électrique (1) comprenant une source de puissance électrique (10) et une pluralité de composants électriques (12₁ à 12₃) reliés électriquement à travers un commutateur électrique (11) à ladite source de puissance électrique (10), **caractérisé en ce qu'**un diagnostic d'une connexion électrique défaillante entre ladite source de puissance électrique (10) et au moins un des composants électriques (12₁ à 12s) provoque une commande d'ouverture (CDC) dudit commutateur électrique (11) pour au moins le circuit électrique dans lequel est diagnostiquée ladite connexion électrique défaillante et/ou une émission d'au moins un signal d'alerte (AL).

5. Système électrique comprenant au moins une source de puissance électrique (10) et au moins un composant électrique (12₁ à 12₃) reliés électriquement à travers un commutateur électrique (11), ledit commutateur électrique (11) étant piloté en commutation par une unité électronique de commande (13), **caractérisé en ce que** lesdits source de puissance électrique (10) et composant électrique (12₁ à 12s) comportent chacun un dispositif de mesure de tension (100 ; 120₁ à 120₃) mesurant une tension électrique (Ub ; Uc1 à Uc3) à leurs bornes et ladite unité électronique de commande (13) comprend une mémoire (MEM) stockant des instructions de programme (LOG) qui, lorsque le programme est exécuté par un processeur de ladite unité électronique de commande, conduisent celui-ci à mettre en oeuvre les étapes du procédé selon l'une quelconque des revendications 1 à 4.

6. Véhicule automobile comprenant un système électrique (1) selon la revendication 5.

## Patentansprüche

1. Verfahren zur Diagnose einer fehlerhaften elektrischen Verbindung in einem elektrischen System (1), das mindestens eine elektrische Stromquelle (10) und mindestens eine elektrische Komponente (12₁ bis 12₃) umfasst, die über einen elektrischen Schalter (11) elektrisch verbunden ist, wobei das Verfahren Folgendes umfasst: die Schritte: a) Messen erster und zweiter elektrischer Spannungen (Ub; Uc1 bis Uc3), die zwischen Anschlüssen der elektrischen Stromquelle (10) und der elektrischen Komponente (12₁ bis 12₃) anliegen, b) Berechnen einer Spannungsdifferenz (EV1 bis EV3). ) zwischen der ersten und der zweiten elektrischen Spannung (Ub; Uc1 bis Uc3), c) Vergleichen der Spannungsdifferenz (EV1 bis EV3) mit einem vorgegebenen Spannungsschwellenwert (TH1 bis TH3), d) Diagnostizieren einer fehlerhaften elektrischen Verbindung zwischen der elektrischen Leistung Quelle (10) und der elektrischen Komponente (12₁ bis 12₃) als Funktion des Ergebnisses des Vergleichs, und e) Steuern einer Öffnung (CDC) des elektrischen Schalters (11) und/oder einer Ausgabe eines Alarmsignals (AL). ) für den Fall, dass eine fehlerhafte elektrische Verbindung diagnostiziert wird, **dadurch gekennzeichnet, dass** der Spannungsschwellenwert (TH1 bis TH3) gleich einem normalen maximalen Spannungsabfall (Umax) zwischen der elektrischen Stromquelle (10) und der elektrischen Komponente (12₁ bis) vorgegeben ist 12₃), wenn die elektrische Verbindung normal ist, multipliziert mit einem Sicherheitsmargenfaktor (M).

2. Verfahren nach Anspruch 1, **dadurch gekennzeichnet, dass** der normale maximale Spannungsabfall (Umax) gleich dem Produkt eines maximalen elektrischen Stroms (Imax) ist, der zwischen der elektrischen Stromquelle (10) und der elektrischen Komponente (12₁) fließen kann 12₃), wenn die elektrische Verbindung normal ist und ein elektrischer Nennwiderstand (R) des Stromkreises zwischen der elektrischen Stromquelle (10) und der elektrischen Komponente (12₁ bis 12₃) vorliegt.

3. Verfahren nach Anspruch 1 oder 2, **dadurch gekennzeichnet, dass** die elektrische Verbindung als fehlerhaft diagnostiziert wird, wenn die Spannungsdifferenz (EV1 bis EV3) den vorgegebenen Spannungsschwellenwert (TH1 bis TH3) für mindestens eine vorgegebene Dauer (DT) überschreitet.

4. Verfahren nach einem der Ansprüche 1 bis 3, in einem elektrischen System (1), das eine elektrische Stromquelle (10) und mehrere elektrische Komponenten (12₁ bis 12₃) umfasst, die über einen elektrischen Schalter (11) elektrisch mit dieser verbunden sind elektrische Stromquelle (10), **dadurch gekennzeichnet, dass** eine Diagnose einer fehlerhaften elektrischen Verbindung zwischen der elektrischen Stromquelle (10) und mindestens einer der elektrischen Komponenten (12₁ bis 12₃) eine Öffnungssteuerung (CDC) des elektrischen Schalters bewirkt (11) für zumindest den Stromkreis, in dem die fehlerhafte elektrische Verbindung diagnostiziert wird, und/oder ein Aussenden mindestens eines Alarmsignals (AL).

5. Elektrisches System mit mindestens einer elektrischen Stromquelle (10) und mindestens einer elektrischen Komponente (12₁ bis 12s), die über einen elektrischen Schalter (11) elektrisch verbunden ist, wobei der elektrische Schalter (11) beim Schalten durch eine Steuerelektronikeinheit gesteuert wird (13), **dadurch gekennzeichnet, dass** die elektrische Energiequelle (10) und die elektrische Komponente (12₁ bis 12₃) jeweils eine Spannungsmessvorrichtung (100; 120₁ bis 120s) umfassen, die an ihren Anschlüssen eine elektrische Spannung (Ub; Uc1 bis Uc3) misst die elektronische Steuereinheit (13) einen Speicher (MEM) umfasst, der Programmanweisungen (LOG) speichert, die, wenn das Programm von einem Prozessor der elektronischen Steuereinheit ausgeführt wird, es dazu antreiben, die Schritte des Verfahrens nach einem der Ansprüche umzusetzen 1 bis 4.

6. Kraftfahrzeug umfassend ein elektrisches System (1) nach Anspruch 5.

## Claims

1. Method for diagnosing a faulty electrical connection in an electrical system (1) comprising at least one electrical power source (10) and at least one electrical component (12₁ to 12₃) electrically connected through an electrical switch (11), said method comprising the steps of a) measuring first and second electrical voltages (Ub; Uc1 to Uc3) present between terminals of said electrical power source (10) and said electrical component (12₁ to 12₃), b) calculating a difference of voltage (EV1 to EV3) between said first and second electrical voltages (Ub; Uc1 to Uc3), c) comparing said voltage difference (EV1 to EV3) to a predetermined voltage threshold (TH1 to TH3), d) diagnosing a connection faulty electrical connection between said electrical power source (10) and said electrical component (12₁ to 12s) as a function of the result of said comparison, and e) controlling an opening (CDC) of said electrical switch (11) and/or an emission of an alert signal (AL) in the case where a faulty electrical connection is diagnosed, **characterized in that** said voltage threshold (TH1 to TH3) is predetermined equal to a normal maximum voltage drop (Umax) between said power source electrical (10) and said electrical component (12₁ to 12s) when said electrical connection is normal, multiplied by a safety margin factor (M).

2. Method according to claim 1, **characterized in that** said normal maximum voltage drop (Umax) is equal to the product of a maximum electric current (Imax) which can flow between said electrical power source (10) and said electrical component (12₁ to 12s) when said electrical connection is normal and a nominal electrical resistance (R) of the electrical circuit between said electrical power source (10) and said electrical component (12₁ to 12s).

3. Method according to claim 1 or 2, **characterized in that** said electrical connection is diagnosed as faulty when said voltage difference (EV1 to EV3) exceeds said predetermined voltage threshold (TH1 to TH3) for at least a predetermined duration (DT).

4. Method according to any one of claims 1 to 3, in an electrical system (1) comprising an electrical power source (10) and a plurality of electrical components (12₁ to 12₃) electrically connected through an electrical switch (11 ) to said electrical power source (10), **characterized in that** a diagnosis of a faulty electrical connection between said electrical power source (10) and at least one of the electrical components (12₁ to 12s) causes a control of opening (CDC) of said electrical switch (11) for at least the electrical circuit in which said faulty electrical connection is diagnosed and/or an emission of at least one alert signal (AL).

5. Electrical system comprising at least one electrical power source (10) and at least one electrical component (12₁ to 12₃) electrically connected through an electrical switch (11), said electrical switch (11) being controlled in switching by a unit control electronics (13), **characterized in that** said electrical power source (10) and electrical component (12₁ to 12₃) each comprise a voltage measuring device (100; 120₁ to 120₃) measuring an electrical voltage (Ub; Uc1 to Uc3) at their terminals and said electronic control unit (13) comprises a memory (MEM) storing program instructions (LOG) which, when the program is executed by a processor of said electronic control unit, drive it to implement the steps of the method according to any one of claims 1 to 4.

6. Motor vehicle comprising an electrical system (1) according to claim 5.
